# EUROPÄISCHE PATENTSCHRIFT

(11) **EP 0 784 866 B1**
(45) Veröffentlichungstag und Bekanntmachung des Hinweises auf die Patenterteilung: **15.04.1998**
(21) Anmeldenummer: 95931136.6
(22) Anmeldetag: 14.09.1995
(51) Int. Cl.: H01L 27/112, H01L 21/8246

(54) **FESTWERT-SPEICHERZELLENANORDNUNG UND VERFAHREN ZU DEREN HERSTELLUNG**
FIXED VALUE STORAGE CELL ARRANGEMENT AND METHOD OF PRODUCING THE SAME
DISPOSITIF DE CELLULES DE MEMOIRE A VALEUR FIXE ET SON PROCEDE DE FABRICATION

(30) Priorität: 28.09.1994 DE 4434725
(43) Veröffentlichungstag der Anmeldung: 23.07.1997
(73) Patentinhaber: SIEMENS AKTIENGESELLSCHAFT, 80333 München (DE)
(72) Erfinder: KRAUTSCHNEIDER, Wolfgang, D-83104 Hohenthann (DE); RISCH, Lothar, D-85579 Neubiberg (DE); HOFMANN, Franz, D-80995 München (DE); RÖSNER, Wolfgang, D-81739 München (DE)
(86) Internationale Anmeldenummer: DE9501262
(87) Internationale Veröffentlichungsnummer: WO9610266

(56) Entgegenhaltungen:
- EP-A- 0 376 568
- DE-A- 4 214 923
- US-A- 4 954 854
- PATENT ABSTRACTS OF JAPAN vol. 016 no. 271 (E-1218) ,18.Juni 1992 & JP,A,04 062966 (FUJITSU LTD) 27.Februar 1992,

## Beschreibung

Für viele elektronische Systeme werden Speicher benötigt, in die Daten in digitaler Form fest eingeschrieben sind. Derartige Speicher werden unter anderem als Festwert-Speicher, Lesespeicher oder Read-Only-Memory bezeichnet.

Für sehr große Datenmengen werden als Lesespeicher vielfach Kunststoffscheiben verwendet, die mit Aluminium beschichtet sind. In der Beschichtung weisen diese Kunststoffscheiben zweierlei punktartige Vertiefungen auf, die den logischen Werten Null und Eins zugeordnet werden. In der Anordnung dieser Vertiefungen ist die Information digital abgespeichert. Derartige Scheiben werden als Compact Disk bezeichnet und sind zur digitalen Abspeicherung von Musik verbreitet.

Zum Lesen der auf einer Compact Disk gespeicherten Daten wird ein Lesegerät verwendet, in dem die Scheibe mechanisch rotiert. Die punktartigen Vertiefungen werden über eine Laserdiode und eine Photozelle abgetastet. Typische Abtastraten sind dabei 2 x 40 kHz. Auf einer Kunststoffscheibe können 4 GBits Informationen gespeichert werden.

Das Lesegerat weist bewegte Teile auf, die mechanischem Verschleiß unterworfen sind, die vergleichsweise viel Volumen benötigen und die nur einen langsamen Datenzugriff erlauben. Das Lesegerät ist darüber hinaus empfindlich gegen Erschütterungen und daher in mobilen Systemen nur begrenzt einsetzbar.

Zur Speicherung kleinerer Datenmengen sind Festwertspeicher auf Halbleiterbasis bekannt. Vielfach werden diese als planare integrierte Siliziumschaltung realisiert, in der MOS-Transistoren verwendet werden. Die Transistoren werden über die Gateelektrode, die mit der Wortleitung verbunden ist, ausgewählt. Der Eingang des MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden die logischen Werte Null und Eins zugeordnet. Technisch wird die Speicherung von Null und Eins dadurch bewirkt, daß in Speicherzellen, in denen der dem Zustand "kein Stromfluß durch den Transistor" zugeordnete logische Wert gespeichert ist, kein MOS-Transistor hergestellt wird oder keine leitende Verbindung zur Bitleitung realisiert wird. Alternativ können für die beiden logischen Werte MOS-Transistoren realisiert werden, die durch unterschiedliche Implantationen im Kanalgebiet unterschiedliche Einsatzspannungen aufweisen.

Diese Speicher auf Halbleiterbasis erlauben einen wahlfreien Zugriff auf die gespeicherte Information. Die zum Lesen der Information erforderliche elektrische Leistung ist deutlich kleiner als bei einem Lesegerät mit einem mechanischen Laufwerk. Da zum Lesen der Information kein mechanisches Laufwerk benötigt wird, entfällt der mechanische Verschleiß und die Empfindlichkeit gegenüber Erschütterungen. Festwertspeicher auf Halbleiterbasis sind daher auch für mobile Systeme einsetzbar.

Die beschriebenen Siliziumspeicher weisen einen planaren Aufbau auf. Damit wird pro Speicherzelle ein minimaler Flächenbedarf erforderlich, der bei etwa 6 bis 8 F² liegt, wobei F die in der jeweiligen Technologie kleinste herstellbare Strukturgröße ist. Planare Siliziumspeicher sind damit bei einer Ein-µm-Technologie auf Speicherdichten um 0,14 bit/µm² begrenzt.

Aus US-PS 4 954 854 ist bekannt, in einem Festwertspeicher vertikale MOS-Transistoren zu verwenden. Dazu wird die Oberfläche eines Siliziumsubstrats mit Graben versehen, an die am Boden ein Sourcegebiet angrenzt, an die an der Substratoberfläche ein Draingebiet angrenzt und entlang deren Flanken ein Kanalgebiet angeordnet ist. Die Oberfläche des Grabens wird mit einem Gatedielektrikum versehen und der Graben mit einer Gateelektrode aufgefüllt. Null und Eins werden in dieser Anordnung dadurch unterschieden, daß für einen der logischen Werte kein Graben geätzt und kein Transistor hergestellt wird.

Aus DE 42 14 923 A1 ist eine Festwert-Speicherzellenanordnung bekannt, deren Speicherzellen MOS-Transistoren umfassen. Diese MOS-Transistoren sind entlang Gräben so angeordnet, daß ein Source-Gebiet an den Boden des Grabens angrenzt, ein Drain-Gebiet an die Oberfläche des Substrats angrenzt und ein Kanalgebiet sowohl vertikal zur Oberfläche des Substrats als auch parallel zur Oberfläche des Substrats an Flanke und Boden des Grabens angrenzt. Die Oberfläche des Kanalgebietes ist mit einem Gatedielektrikum versehen. Die Gateelektrode ist als Flankenbedeckung (Spacer) ausgebildet. Die logischen Werte Null und Eins werden durch unterschiedliche Einsatzspannungen, die durch Kanalimplantation bewirkt werden, unterschieden. Bei der Kanalimplantation treffen die implantierenden Ionen unter einem solchem Winkel auf die Oberflächen des jeweiligen Grabens, daß durch Abschattungseffekte der gegenüberliegenden Flanke gezielt nur entlang einer Flanke implantiert wird.

Aus EP-A-0 376 568 ist eine Festwertspeicherzellenanordnung bekannt, in der Daten in Form zweier unterschiedlicher Versorgungsspannungen gespeichert werden. Jede Speicherzelle umfaßt dabei zwei MOS-Transistoren, die über ein gemeinsames Source-/Draingebiet in Reihe verschaltet sind. Das gemeinsame Source-/Draingebiet ist über einen Kontakt mit der zugehörigen Bitleitung verbunden. Der eine der MOS-Transistoren der Speicherzelle ist dabei zwischen die erste Versorgungsspannungsquelle und das gemeinsame Source-/Draingebiet geschaltet, der andere zwischen die zweite Versorgungsspannungsquelle und das gemeinsame Source-/Draingebiet. Einer der MOS-Transistoren weist ein dünnes Gateoxid, der andere ein dickes Gateoxid auf. Bei Anliegen einer Auswahlspannung an der zugehörigen Wortleitung, die mit beiden Gateelektroden der beiden MOS-Transistoren der Speicherzelle verbunden ist, leitet der eine MOS-Transistor, während der andere sperrt. Dadurch liegt an dem gemeinsamen Source-/Draingebiet das Potential derjenigen Versorgungsspannungsquelle an, die mit dem MOS-Transistor mit dem dünnen Gateoxid verbunden ist. Beim Auslesen der Information wird der Pegel, der an der Bitleitung anliegt, bewertet. Da in der Speicherzelle jeweils einer der MOS-Transistoren ein dünnes Gateoxid und der andere MOS-Transistors ein dickes Gateoxid aufweist, fließt für beide logischen Werte jeweils ein Strom über die Bitleitung. Die Bitleitung wird alternativ mit einer der beiden Spannungsquellen verbunden.

Der Erfindung liegt das Problem zugrunde, eine Festwert-Speicherzellenanordnung auf Halbleiterbasis anzugeben, bei der eine erhöhte Speicherdichte erzielt wird und die mit wenigen Herstellungsschritten und hoher Ausbeute herstellbar ist. Desweiteren soll ein Verfahren zur Herstellung einer solchen Speicherzelleanordnung angegeben werden.

Dieses Problem wird erfindungsgemäß gelöst durch eine Festwert-Speicherzellenanordnung gemäß Anspruch 1 sowie durch ein Verfahren zu deren Herstellung gemäß Anspruch 8. Weitere Aus gestaltungen der Erfindung ergeben sich aus den Unteransprüchen.

Die erfindungsgemäße Festwert-Speicherzellenanordnung umfaßt MOS-Transistoren, in denen ein Stromfluß zwischen Source- und Drain-Gebiet im wesentlichen senkrecht zur Oberfläche des Substrats erfolgt. Zur Unterscheidung der beiden logischen Werte Null und Eins weisen die MOS-Transistoren unterschiedlich dicke Gatedielektrika auf. Dabei wird ausgenutzt, daß bei einem Unterschied der Dicken der Gatedielektrika um einen Faktor von 10 oder mehr sich die Einsatzspannungen der MOS-Transistoren so deutlich unterscheiden, daß bei Anlegen eines Auswahlsignales mit einem Pegel zwischen beiden Einsatzspannungen der eine MOS-Transistor leitet und der mit dem dickeren Gatedielektrikum nicht leitet.

Als Halbleitersubstrat ist insbesondere ein Substrat aus monokristallinem Silizium oder ein SOI-Substrat geeignet, in dessen Siliziumschicht die Speicherzellenanordnung realisiert wird. Für Massenanwendungen, wie zum Beispiel Datenträger für Information oder digital abgespeicherte Musik, wird ein Halbleitersubstrat aus monokristallinem Silizium bevorzugt.

Die unterschiedliche Dicke der Gatedielektrika wird vorzugsweise durch Aufbringen einer isolierenden Schicht erreicht, die an der Oberfläche der Kanalgebiete der MOS-Transistoren, die eine geringe Dicke des Gatedielektrikums aufweisen sollen, selektiv entfernt wird. Die unterschiedliche Dicke der Gatedielektrika kann auch durch selektive Oxidation, zum Beispiel einen LOCOS-Prozeß, mit unterschiedlichen Oxidationszeiten erfolgen.

Es liegt im Rahmen der Erfindung, außerhalb des Zellenfelds mit den Speicherzellen auf demselben Halbleitersubstrat eine Ausleseschaltung zu realisieren. Bei der Herstellung der Anordnung werden in der Ausleseschaltung benötigte MOS-Transistoren vorzugsweise gleichzeitig mit den MOS-Transistoren der Speicherzellen hergestellt. Die MOS-Transistoren für die Ausleseschaltung können dabei sowohl als vertikale MOS-Transistoren mit einem zur Oberfläche des Substrats senkrechten Stromfluß zwischen Source und Drain als auch als laterale MOS-Transistoren mit einem zur Oberfläche des Substrats parallelen Stromfluß zwischen Source und Drain realisiert werden.

Gemäß einer ersten Ausführungsform der Erfindung grenzen die vertikalen MOS-Transistoren der Speicherzellen jeweils an eine Flanke eines Grabens an. Die gegenüberliegende Flanke des Grabens ist mit einer isolierenden Schicht bedeckt. Bitleitung und Referenzleitung verlaufen als dotierte Gebiete vergraben im Substrat. Die Wortleitungen sind mit den Gateelektroden der MOS-Transistoren verbunden und verlaufen quer zu den Bit- und Referenzleitungen. Diese Ausführungsform ist mit einer minimalen Speicherzellenfläche von 4 F² (F: minimale Strukturgröße bei der jeweiligen Technologie) herstellbar.

Gemäß einer anderen Ausführungsform der Erfindung sind an gegenüberliegenden Flanken jedes Grabens MOS-Transistoren angeordnet, deren Gateelektroden gegeneinander isoliert sind. Die Gateelektroden werden dabei als Flankenbedeckungen (Spacer) an den jeweiligen Flanken realisiert. Die Flankenbedeckung aus leitfähigem Material, vorzugsweise dotiertem Polysilizium, verläuft über die gesamte Länge der Flanke des Grabens, so daß die Gateelektroden aller an dieser Flanke des Grabens angrenzenden MOS-Transistoren miteinander verbunden sind. Die Flankenbedeckung bildet die Wortleitung für diese MOS-Transistoren. Diese Ausführungsform kann mit einer minimalen Speicherzellenfläche von 2 F² hergestellt werden.

Bei Zugrundelegung einer 0,35 um-Technologie ist die erfindungsgemäße Speicherzellenanordnung mit einer Speicherzellenfläche von ca. 0,25 µm² herstellbar. Eine Festwert-Speicherzellenanordnung mit 100 bis 500 MBit bei einer Fläche von etwa 1 cm² ist damit technisch und wirtschaftlich machbar.

Mit einer Datenkompression von ca. 10:1, wie sie von speziellen Algorithmen oder Signalprozessoren bekannt ist, werden dann bis zu 5 GBit erreicht. Damit ist die erfindungsgemäße Festwert-Speicherzellenanordnung für Anwendungen wie zum Beispiel die digitale Speicherung von Musik einsetzbar, für die bislang Compact-Disks verwendet wurden. PC-Software sowie Spiele benötigen eine weniger hohe Speicherdichte und können daher auch ohne Datenkompression in einer erfindungsgemäßen Festwert-Speicherzellenanordnung gespeichert werden.

Im folgenden wird die Erfindung anhand von Ausführungsbeispielen und den Figuren näher erläutert. Der Deutlichkeit halber sind die Darstellungen in den Figuren nicht maßstabsgerecht.
- Figur 1: zeigt ein Siliziumsubstrat mit Gräben, an die dotierte Gebiete für Source, Kanal und Drain angrenzen und deren Oberfläche mit einer isolierenden Schicht bedeckt ist.
- Figur 2: zeigt das Substrat nach der Herstellung einer erfindungsgemäßen Speicherzellenanordnung mit MOS-Transistoren mit dickem und dünnem Gateoxid.
- Figur 3: zeigt den in Figur 2 mit III-III bezeichneten Schnitt.
- Figur 4: zeigt den in Figur 2 mit IV-IV bezeichneten Schnitt.
- Figur 5: zeigt eine Aufsicht auf das Zellenfeld der in Figur 2 dargestellten Speicherzellenanordnung, in dem die einzelne Speicherzelle einen Platzbedarf von 4 F² aufweist.
- Figur 6: zeigt ein Siliziumsubstrat mit Gräben, an die ein Source-Gebiet und ein Kanalgebiet angrenzen und die mit einer isolierenden Schicht bedeckt sind.
- Figur 7: zeigt das Siliziumsubstrat nach Erzeugung einer isolierenden Flankenbedeckung, nach einer Gateoxidation und nach Abscheidung einer Polysiliziumschicht.
- Figur 8: zeigt das Siliziumsubstrat nach Erzeugung von leitfähigen Flankenbedeckungen aus der dotierten Polysiliziumschicht.
- Figur 9: zeigt den in Figur 8 mit IX-IX bezeichneten Schnitt nach dem Auftrennen der leitfähigen Flankenbedeckungen.
- Figur 10: zeigt das Siliziumsubstrat nach der Herstellung von MOS-Transistoren für eine Ausleseschaltung außerhalb des Zellenfeldes.
- Figur 11: zeigt das Siliziumsubstrat nach der Herstellung der erfindungsgemäßen Speicherzellenanordnung, wobei gegenüberliegende leitfähige Flankenbedeckungen in jedem Graben durch eine isolierende Schicht voneinander isoliert sind, wobei nach der Isolation der leitfähigen Flankenbedeckungen zwischen den Gräben Drain-Gebiete erzeugt worden sind und die Drain-Gebiete mit einer Metallisierung versehen worden sind.
- Figur 12: zeigt eine Aufsicht auf das Zellenfeld der in Figur 11 dargestellten Speicherzellenanordnung mit einem Flächenbedarf der einzelnen Speicherzelle von 2 F².

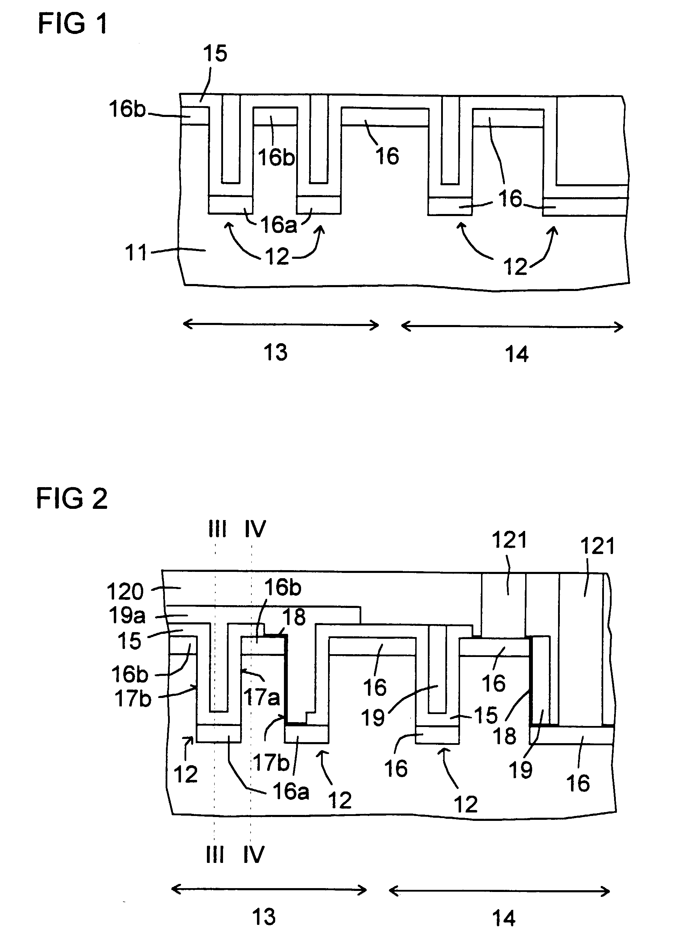

In einem Substrat aus monokristallinem Silizium, das zum Beispiel p-dotiert ist und eine Dotierstoffkonzentration von zum Beispiel 5 x 10¹⁶ cm⁻³ aufweist, werden unter Verwendung einer Grabenmaske durch anisotropes Ätzen Gräben 12 erzeugt (siehe Figur 1). Das Substrat 11 umfaßt einen Bereich für ein Zellenfeld 13 und einen Bereich für eine Peripherie 14 in der zum Beispiel eine Ausleseschaltung und/oder Verstärker, D/A-Wandler und ähnliches hergestellt werden. Der Bereich für das Zellenfeld 13 ist in Figur 1 als Doppelpfeil 13, der Bereich für die Peripherie 14 als Doppelpfeil 14 eingetragen.

Im Bereich des Zellenfeldes 13 verlaufen die Gräben 12 parallel über das Substrat. Sie weisen eine Tiefe von zum Beispiel 1 µm auf. Die Breite der Gräben 12 wird entsprechend der minimalen Strukturgröße F der verwendeten Technologie, zum Beispiel 0,35 µm gewählt. Der Abstand der Gräben 12 wird ebenfalls entsprechend der minimalen Strukturgröße F, zum Beispiel 0,35 µm gewählt. Die Länge der Gräben senkrecht zu der in Figur 1 dargestellten Zeichenebene beträgt zum Beispiel 250 µm.

Die in der Peripherie 14 angeordneten Gräben werden zur späteren Herstellung von MOS-Transistoren für die Ansteuerschaltung realisiert. Die Tiefe dieser Gräben 12 ist dieselbe wie in dem Zellenfeld 13, der Querschnitt und Abstand der Gräben wird jedoch an die Anforderungen der Ansteuerschaltung angepaßt. Insbesondere werden größere Abstände und größere Breiten der Gräben realisiert.

Anschließend wird ganzflächig eine isolierende Schicht 15 abgeschieden. Die isolierende Schicht 15 wird zum Beispiel in einem CVD-Verfahren durch thermische Zersetzung von Si(OC₂H₅)₄ (TEOS) aus SiO₂ erzeugt. Die Schichtdicke der isolierenden Schicht 15 beträgt zum Beispiel 100 nm. Die isolierende Schicht 15 weist eine im wesentlichen konforme Kantenbedeckung auf.

Durch Ionenimplantation von zum Beispiel Phosphor werden nachfolgend am Boden der Gräben 12 sowie zwischen den Gräben 12 an der Oberfläche des Substrats 11 n⁺-dotierte Gebiete 16 erzeugt. Die am Boden der Gräben 12 angeordneten Gebiete 16a verlaufen senkrecht zur Zeichenebene. Im Bereich des Zellenfeldes 13 werden die Gräben 16a als Referenzleitungen verwendet. An der Oberfläche des Substrats 11 verlaufende n⁺-Gebiete 16b verlaufen ebenfalls senkrecht zur Zeichenebene in Figur 1. Im Bereich des Zellenfeldes 13 werden die n⁺-dotierten Gebiete 16b als Bitleitungen verwendet.

Unter Verwendung einer Maske aus zum Beispiel Photolack wird nachfolgend die isolierende Schicht 15 strukturiert (siehe Figur 2). Im Bereich des Zellenfeldes bleibt dabei jeweils eine erste Flanke 17a mit der isolierenden Schicht 15 bedeckt. An einer zweiten Flanke 17b, die der ersten Flanke 17a jeweils gegenüberliegt, wird die dielektrische Schicht 14 dagegen selektiv entfernt. Die dielektrische Schicht 15 wird dort entfernt, wo später ein MOS-Transistor mit geringerer Einsatzspannung entstehen soll. Die Öffnungen, die dabei in die isolierende Schicht 15 geätzt werden, weisen eine Breite von einer Strukturgröße F und eine Länge senkrecht zur Zeichenebene in Figur 2 von ebenfalls einer Strukturgröße F auf. Bezüglich der Anordnung der Gräben 12 sind die Öffnungen jedoch um eine halbe Strukturgröße 1/2 F lateral verschoben. Dabei wird ausgenutzt, daß die Justiergenauigkeit stets größer als die kleinste Strukturgröße ist.

In der Peripherie 14 wird die isolierende Schicht 15 entsprechenden den Anforderungen der Ansteuerschaltung strukturiert. Sie wird insbesondere entlang Flanken von Gräben 12 entfernt, an denen vertikale MOS-Transistoren gebildet werden sollen.

Die Strukturierung der isolierenden Schicht 15 erfolgt zum Beispiel mit anisotropen Ätzverfahren.

Es folgt eine Gateoxidation bei zum Beispiel 825 °C in trokkener O₂ Atmosphäre, bei der an freiliegenden Siliziumoberflachen ein Gatedielektrikum 18 in einer Dicke von zum Beispiel 7 nm gebildet wird.

Anschließend wird ganzflächig eine Polysiliziumschicht 19 aufgebracht und durch Implantation oder Belegung n-dotiert. Die Polysiliziumschicht 19 wird mit einer Schichtdicke von zum Beispiel 250 nm abgeschieden. Dadurch füllt die Polysiliziumschicht 19 die Gräben 12 im Zellenfeld vollständig auf.

Anschließend wird unter Verwendung einer Maske die Polysiliziumschicht 19 strukturiert. Dabei werden im Bereich des Zellenfeldes 13 parallel angeordnete, streifenförmig verlaufende Wortleitungen 19a gebildet. Der in die Gräben hineinreichende Teil der Wortleitungen 19a bildet Gateelektroden für die an den zweiten Flanken 17b der Gräben angeordneten MOS-Transistoren. Diese MOS-Transistoren umfassen jeweils ein n⁺-dotiertes Gebiet 16a am Boden des jeweiligen Grabens 12, ein an der Oberfläche des Substrats an dieselbe zweite Flanke 17b angrenzendes n⁺-dotiertes Gebiet 16b sowie den dazwischen angeordneten Teil des Substrats 11 als Kanalgebiet, das Gateoxid 18 oder die isolierende Schicht 15 als Gatedielektrikum sowie besagte Gateelektrode. MOS-Transistoren mit einem dünnen Gateoxid 18 als Gatedielektrikum weisen eine deutlich geringere Einsatzspannung auf als MOS-Transistoren mit der isolierenden Schicht 15 als Gatedielektrikum. Beträgt die Dicke der Gateoxidschicht 18 7 nm und die Dicke der isolierenden Schicht 15 100 nm und wird an die Wortleitung 19a ein Auswahlsignal von 3,5 Volt angelegt, so leiten nur diejenigen MOS-Transistoren, die ein dünnes Gateoxid 18 als Gatedielektrikum aufweisen.

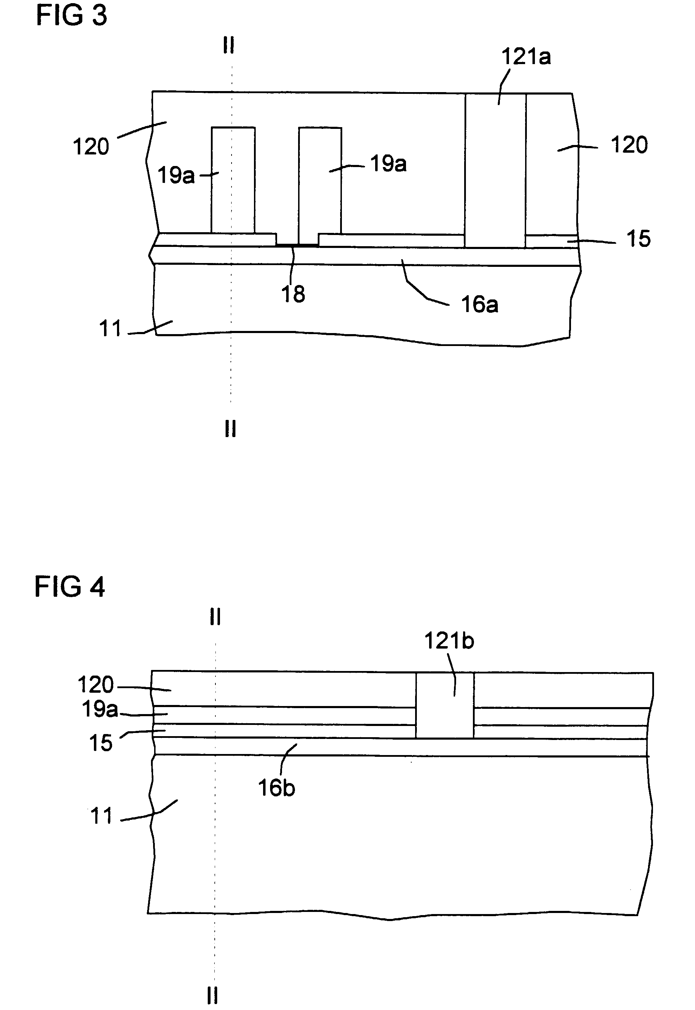

Zur Fertigstellung der Speicherzellenanordnung wird ganzflächig eine Zwischenoxidschicht 120 aus zum Beispiel Bor-Phosphor-Silikat-Glas in einer Schichtdicke von ca. 800 nm abgeschieden. In der Zwischenoxidschicht 120 werden Kontaktlöcher zu den Referenzleitungen 16a (siehe Figur 3), zu den Bitleitungen 16b (siehe Figur 4) sowie zu den Wortleitungen und den MOS-Transistoren in der Peripherie 14 geöffnet. Durch Auffüllung der Kontaktlöcher mit Wolfram wird ein Referenzleitungskontakt 121a (siehe Figur 3), ein Bitleitungskontakt 121b (siehe Figur 4) sowie weitere Kontakte 121, zum Beispiel für die MOS-Transistoren in der Peripherie 14 gebildet.

Durch Abscheidung und Strukturierung einer Metallisierungsebene aus zum Beispiel Aluminium und durch Erzeugung und Strukturierung einer Passivierungsschicht aus zum Beispiel Plasmaoxid wird die Speicherzellenanordnung fertiggestellt (diese Schritte sind nicht im einzelnen dargestellt).

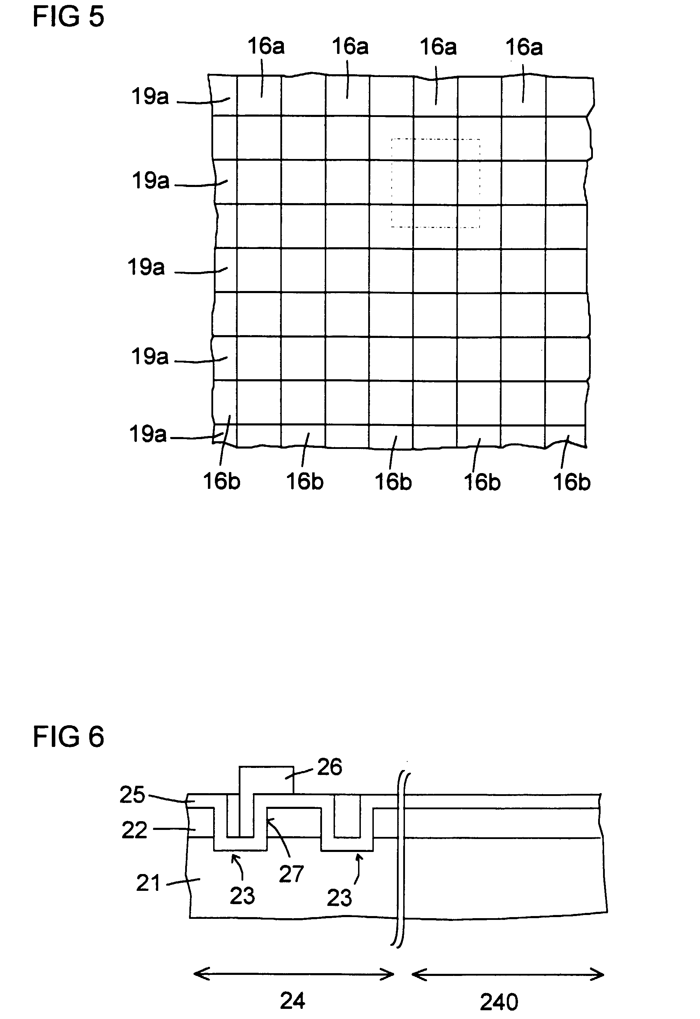

In dieser Speicherzellenanordnung verlaufen im Zellenfeld 13 die Wortleitungen 19a parallel zueinander (siehe Aufsicht in Figur 5). Senkrecht zu den Wortleitungen 19a verlaufen die Referenzleitungen 16a am Boden der Gräben 12, die ebenfalls streifenförmig sind und parallel zueinander angeordnet sind. Ebenfalls senkrecht zu den Wortleitungen 19a verlaufen die Bitleitungen 16b, die zwischen benachbarten Gräben 12 an die Oberfläche des Substrats 11 angrenzen. In der Aufsicht in Figur 5 erscheinen jeweils zwischen benachbarten Referenzleitungen 16a eine Bitleitung 16b. Als strichpunktierte Linie ist in Figur 5 die Fläche einer Speicherzelle eingetragen. Da die Breite der Wortleitungen 19a, der Bitleitungen 16b sowie der Referenzleitungen 16a jeweils eine minimale Strukturgröße F von zum Beispiel 0,35 µm beträgt und da deren Abstand ebenfalls eine minimale Strukturgröße F von zum Beispiel 0,35 µm beträgt, wird für jede Speicherzelle eine Fläche von 4 F² = 0,5 µm² benötigt. Damit ist eine Speicherdichte von 2 bit/µm² erzielbar.

Die Ausdehnung des Zellenfeldes 13 beträgt parallel zur Oberfläche des Substrats 11 zum Beispiel 250 x 250 µm². Darin können 125 kBit Informationen gespeichert werden.

In einem weiteren Ausführungsbeispiel wird eine Festwert-Speicherzellenanordnung auf einem Substrat 21 aus n⁺-dotiertem, monokristallinem Silizium aufgebaut. Das Substrat 21 ist zum Beispiel mit Arsen dotiert und weist eine Leitfähigkeit von etwa 100 mΩ cm auf. Auf dem Substrat 21 ist eine p-dotierte Schicht 22 angeordnet, die eine Dicke von zum Beispiel 0,3 µm aufweist und die eine Bor-Dotierung von zum Beispiel 5 x 10¹⁷ cm⁻³ aufweist. Die p-dotierte Schicht 22 wird entweder durch Ionenimplantation oder durch epitaktisches Aufwachsen erzeugt (siehe Figur 6).

Nach Erzeugen einer Ätzmaske mit Hilfe von Photolithographie (nicht im einzelnen dargestellt) werden in der Oberfläche der p-dotierten Schicht 22 mit Hilfe eines Trockenätzprozesses Gräben 23 geätzt. Die Gräben 23 reichen bis in das n⁺-dotierte Substrat 21 hinein. Sie weisen eine Tiefe von zum Beispiel 0,4 µm auf. Die Gräben 23 sind in einem Zellenfeld 24 in dem Substrat 21 angeordnet. Sie verlaufen als parallel angeordnete Streifen über das Zellenfeld 24. Die Breite der Gräben 23 sowie deren Abstand wird jeweils in einer minimalen Strukturgröße F von zum Beispiel 0,6 µm realisiert. Die Länge der Gräben 23 senkrecht zu der in Figur 6 gezeigten Zeichenebene beträgt zum Beispiel 250 µm. Die Fläche des Zellenfeldes 24 parallel zur Oberfläche des Substrats 21 beträgt zum Beispiel 250 x 250 µm². Neben dem Zellenfeld 24 umfaßt das Substrat 21 eine Peripherie 240, in der eine Ausleseschaltung und ähnliches realisiert werden.

Es wird ganzflächig auf die Oberfläche der p-dotierten Schicht 22 und der Gräben 23 eine isolierende Schicht 25 aus zum Beispiel SiO₂ in einer Dicke von zum Beispiel 100 nm erzeugt. Die isolierende Schicht 25 wird zum Beispiel in einem TEOS-Verfahren abgeschieden.

Nachfolgend wird eine Photolackmaske 26 erzeugt, die diejenigen Bereiche der isolierenden Schicht 25 abdeckt, in denen im Zellenfeld 24 MOS-Transistoren mit größerer Einsatzspannung gebildet werden sollen. Pro MOS-Transistor wird dabei eine Fläche mit einer Größe von 1 F x 1 F, F: minimale Strukturgröße, zum Beipsiel 0,6 µm, abgedeckt. Gegenüber der Anordnung der Gräben 23 sind die Strukturen der Photolackmaske 26 um 1/2 F seitlich verschoben, so daß die Strukturen der Photolackmaske 26 einen Teil der Flanken 27 der Gräben 23 bedekken. Hier wird ausgenutzt, daß die Justiergenauigkeit größer ist, als es der minimalen Strukturbreite entspricht.

Unter Verwendung der Photolackmaske 26 als Ätzmaske wird die isolierende Schicht 25 in einem isotropen Ätzprozeß zum Beispiel mit gepufferter Flußsäure strukturiert. Anschließend wird die Photolackmaske 26 entfernt.

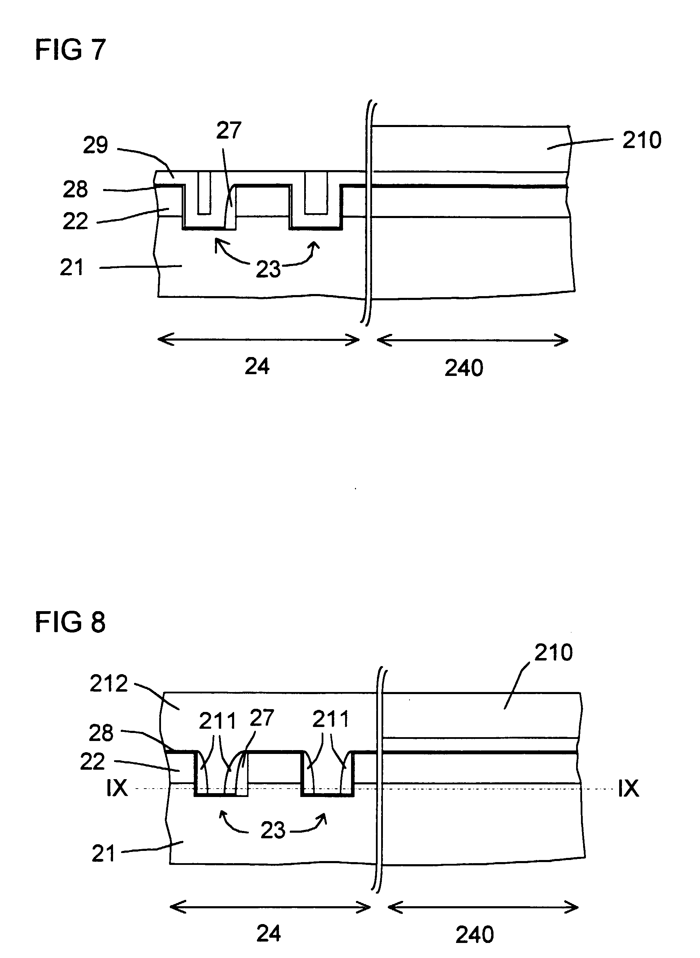

Anschließend wird eine anisotrope Ätzung selektiv zu Silizium durchgeführt, bei der aus der strukturierten isolierenden Schicht isolierende Flankenbedeckungen 27 (Spacer) gebildet werden. Als anisotroper Ätzprozeß ist dabei zum Beispiel reaktives Ionenätzen geeignet (siehe Figur 7).

Die Prozeßschritte zur Bildung der isolierenden Flankenbedeckungen 27 und zur Strukturierung der isolierenden Schicht 25 können auch in umgekehrter Reihenfolge durchgeführt werden. In diesem Fall wird die Photolackmaske 26 erst nach der Bildung der Flankenbedeckungen 27 erzeugt.

Es folgt eine Gateoxidation bei zum Beispiel 825 °C in O₂-Atmosphäre, bei der auf freiliegenden Siliziumoberfächen der p-dotierten Schicht 22 sowie der Gräben 23 eine Gateoxidschicht 28 in einer Dicke von zum Beispiel 7 nm erzeugt wird. Anschließend wird ganzflächig eine Polysiliziumschicht 29 abgeschieden. Durch Implantation oder Belegung wird die Polysiliziumschicht 29 n-dotiert. Mit Hilfe eines photolithographischen Verfahrens wird eine Maske 210 gebildet, die die Peripherie 25 abdeckt. Das Zellenfeld 24 wird von der Maske 210 nicht abgedeckt. Am Rand des Zellenfeldes 24 deckt die Maske 210 zusätzlich Anschlußflecken für Wortleitungen ab.

In einem anisotropen Trockenätzprozeß selektiv zu SiO₂ werden aus der dotierten Polysiliziumschicht 29 leitfähige Flankenbedeckungen 211 an den Flanken der Gräben 23 gebildet. Die leitfähigen Flankenbedeckungen 211 bestehen aus dotiertem Polysilizium. Die anisotrope Ätzung, die zum Beispiel durch reaktives Ionenätzen erfolgt, wird soweit überzogen, daß waagerechte Oberflächen der Gateoxidschicht 28 freigelegt werden (siehe Figur 8). Die leitfähigen Flankenbedeckungen 211 umgeben herstellungsbedingt die einzelnen Gräben 23 ringförmig.

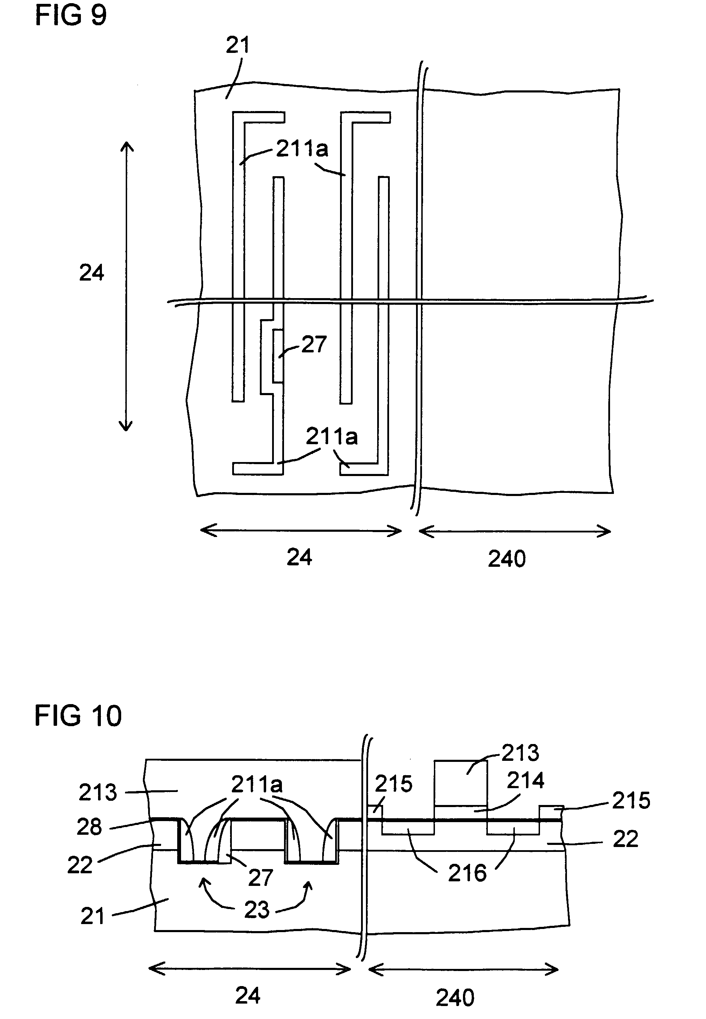

Im nächsten Schritt wird eine weitere Maske 212 erzeugt, um die in jedem Graben 23 ringförmigen leitfähigen Flankenbedeckungen 211 durch eine Ätzung an zwei Stellen zu unterbrechen. Die Maske 212 deckt daher das Zellenfeld 24 im wesentlichen ab und läßt nur jeweils zwei Stellen jeder leitfähigen Flankenbedeckung 211 unbedeckt. Vorzugsweise werden die leitfähigen Flankenbedeckungen 211 jeweils an den langen Seiten des Grabens 23 aufgetrennt, wobei die Auftrennungsstellen an entgegengesetzten Enden der langen Seiten angeordnet sind (siehe Figur 9, die einen Schnitt IX-IX durch Figur 8 darstellt). Auf diese Weise entstehen im wesentlichen streifenförmige, parallel angeordnete Wortleitungen 211a. Die Wortleitungen 211a weisen jeweils abwechselnd auf verschiedenen Seiten des Zellenfeldes eine rechtwinkelige Verlängerung auf, über die im weiteren Verlauf eine Kontaktierung der Wortleitungen 211a erfolgt. Da die Kontaktierung für benachbarte Wortleitungen 211a jeweils auf entgegengesetzten Seiten des Zellenfeldes 24 erfolgt, ist dieser Prozeßschritt unkritisch.

Nach Entfernen der Masken 210 und 212 wird eine weitere Maske 213 aufgebracht, die das Zellenfeld 24 vollständig abdeckt und die in der Peripherie 240 Gateelektroden für MOS-Transistoren einer Ausleseschaltung definiert (siehe Figur 10). In einem anisotropen Trockenätzprozeß zum Beispiel mit reaktivem Ionenätzen werden durch Strukturierung der Polysiliziumschicht 29 in der Peripherie 240 Gateelektroden 214 gebildet. Unter Verwendung einer weiteren Maske 215 und den Gateelektroden 214 als Implantationsmaske werden den Gateelektroden 214 benachbart durch Implantation Source- und Drain-Gebiete 216 gebildet.

Nach Entfernen der Masken 213, 215 wird ganzflächig eine planarisierende Isolationsschicht 217 erzeugt. Dieses erfolgt zum Beispiel durch Abscheidung und Verfließenlassen von Bor-Phosphor-Silikat-Glas.

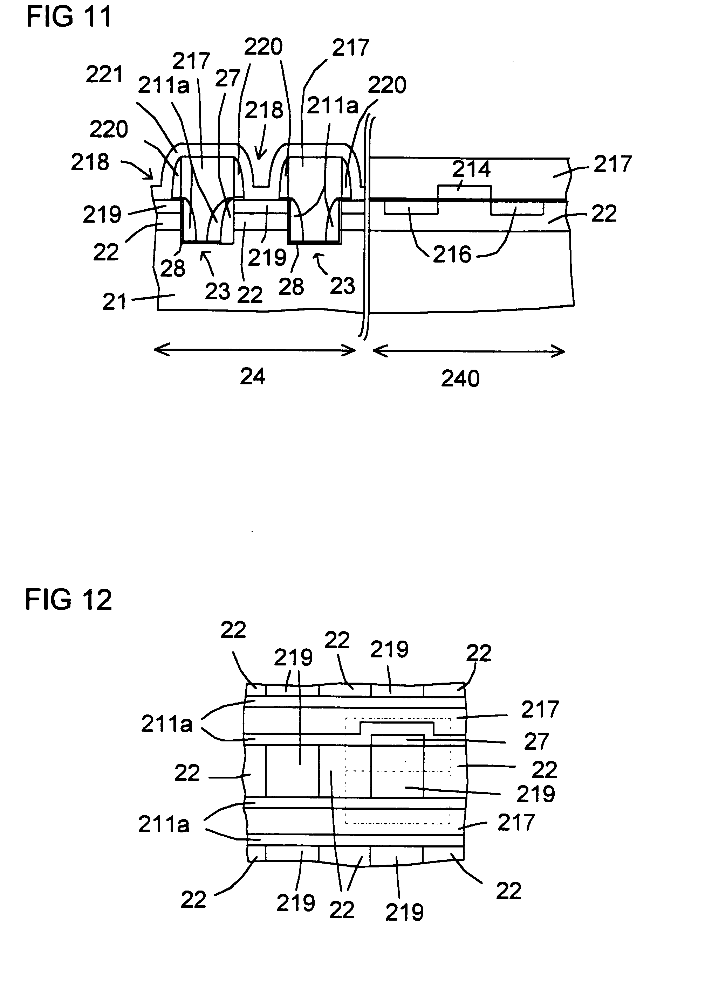

Mit Hilfe einer weiteren Maske (nicht dargestellt) werden im Zellenfeld 24 Kontaktlöcher auf die Oberfläche der p-dotierten Schicht 22 zwischen den Gräben 23 geöffnet. Zur Öffnung der Kontaktlöcher 218 wird eine Trockenätzung, zum Beispiel reaktives Ionenätzen verwendet. Anschließend folgt eine Ionenimplantation zum Beispiel mit Arsen bei einer Implantationsenergie von 25 keV und einer Dosis von 5 x 10¹⁵ cm⁻³. Bei der Implantation werden n⁺-dotierte Gebiete 219 an der Oberfläche der p-dotierten Schicht 22 zwischen benachbarten Gräben 23 gebildet (siehe Figur 11). Die n⁺-dotierten Gebiete 219, die eine Dotierstoffkonzentration von zum Beispiel 10²⁰ cm⁻³ aufweisen, stellen Drain-Gebiete von MOS-Transistoren dar, die entlang der Flanken der Gräben 23 angeordnet sind. Die MOS-Transistoren werden gebildet aus dem n⁺-dotierten Substrat 21, das ein Source-Gebiet bildet, der p-dotierten Schicht 22, die ein Kanalgebiet bildet, dem n⁺-dotierten Gebiet 219, der Gateoxidschicht 28 bzw. der isolierenden Flankenbedeckung 27 sowie der Wortleitung 211a, die die Gateelektrode bildet. Diejenigen MOS-Transistoren, die einen Teil der Gateoxidschicht 28 als Gatedielektrikum aufweisen, werden bei einer geringeren Einsatzspannung leitend als diejenigen MOS-Transistoren, die als Gatedielektrikum eine isolierende Flankenbedeckung 27 aufweisen.

Bei diesem Implantationsschritt können auch gleichzeitig dotierte Gebiete in der Peripherie 240 hergestellt werden.

Die planarisierende Schicht 217 isoliert an gegenüberliegenden Flanken ein und desselben Grabens 23 angeordnete Wortleitungen 211a gegeneinander. Da die Grabenweite und der Grabenabstand jeweils eine minimale Strukturgröße betragen, kann es bei der Öffnung der Kontaktlöcher 218, deren Weite ebenfalls eine Minimalstrukturgröße trägt, infolge von Justierungenauigkeit zu einem Freiätzen von Wortleitungen 211a im oberen Bereich kommen. Um dennoch eine sichere Isolation der Wortleitungen untereinander zu erzielen, wird in einem CVD-Verfahren durch thermische Zersetzung von Si(OC₂H₅)₄ (TEOS) eine SiO₂-Schicht mit im wesentlichen konformer Kantenbedeckung abgeschieden. In einem anisotropen Ätzprozeß selektiv zu Silizium und zu Bor-Phosphor-Silikat-Glas, zum Beispiel mit reaktivem Ionenätzen, werden an den Flanken der Kontaktlöcher 218 isolierende Flankenbedeckungen 220 (Spacer) gebildet, die bei der Kontaktlochätzung freigelegte Wortleitungen 211a zusätzlich isolieren.

Schließlich wird zum Beispiel durch Sputtern eine Metallschicht aus zum Beispiel Aluminium aufgebracht, die mit Hilfe einer Photolackmaske zur Bildung von Bitleitungen 221 in einem Ätzprozeß strukturiert wird. Die Bitleitungen 221 verlaufen senkrecht zu den Wortleitungen 211a. Die Bitleitungen 221 sind über die Kontaktlöcher 218 selbstjustiert mit den n⁺-dotierten Gebieten 219 der MOS-Transistoren verbunden. Das n⁺-dotierte Substrat 21, das für alle MOS-Transistoren des Zellenfeldes 24 das andere Source/Drain-Gebiet bildet, wird mit einem Substratkontakt versehen. Dieses kann auf der Rückseite des Substrats 21 erfolgen oder am Rand des Zellenfeldes 24 über ein Kontaktloch, das die p-dotierte Schicht 22 durchquert.

Figur 12 zeigt eine Aufsicht auf einen Ausschnitt aus dem Zellenfeld dieser Ausführungsform der erfindungsgemäßen Speicherzellenanordnung. An jeden Graben grenzen zwei Speicherzellen an. Jede Speicherzelle umfaßt einen MOS-Transistor, der aus n⁺-dotiertem Gebiet 219, p-dotierter Schicht 22 als Kanalgebiet, Substrat 21 als Source/Drain-Gebiet, Gatedielektrikum und Wortleitung 211a gebildet wird. Die zwischen benachbarten Gräben 23 angeordneten dotierten Gebiete 219, 22 gehören jeweils zwei MOS-Transistoren an. Daher beträgt der Flächenbedarf für eine Speicherzelle 2F², wobei F die minimale Strukturgröße, zum Beispiel 0,6 µm ist. Bei Einsatz einer Technologie mit einer minimalen Strukturgröße F von 0,25 µm kann auf diese Weise eine Speicherzelle mit 0,125 µm² Fläche erzeugt werden.

In der Aufsicht in Figur 12 sind die Übersichtlichkeit halber nur die isolierenden Flankenbedeckung 27, jedoch nicht die Gateoxidschichten 28 eingetragen.

Die n⁺-dotierten Gebiete 219 von entlang einer Flanke eines Grabens benachbarten MOS-Transistoren sind gegeneinander isoliert. In der beschriebenen Ausführungsform wird diese Isolierung durch die pn-Übergänge die jeweils am Rand der Kontaktlöcher 218 zur p-dotierten Schicht 22 gebildet werden, realisiert. Alternativ können die n⁺-dotierten Gebiete 219 durch Isolationsgräben gegeneinander isoliert werden. Diese Isolationsgräben werden durch eine Grabenätzung und eine Auffüllung mit isolierendem Material vor der Ätzung der zuerst genannten Gräben 23 hergestellt.

Am Rand des Zellenfeldes 24 ist jeweils ein Graben 23 mit isolierender Flankenbedeckung 27 vorgesehen, der die Kanalgebiete der am Rande angeordneten MOS-Transistoren gegen die Peripherie 240 isoliert. Zum Ausgleich möglicher Justiertoleranzen, kann die Breite dieses Grabens größer als eine Strukturgröße F ausgeführt werden.

## Patentansprüche

1. Festwert-Speicherzellenanordnung
- bei der ein Substrat (11) aus Halbleitermaterial vorgesehen ist, das im Bereich einer Hauptfläche in einem Zellenfeld angeordnete Speicherzellen umfaßt,
- bei der die Speicherzellen jeweils einen MOS-Transistor mit zwei Source/Drain-Gebieten (16a, 16b), Kanalgebiet (11), Gatedielektrikum (18; 15) und Gateelektrode (19a) umfassen, dessen eines Source/Drain-Gebiet (16a) mit einer Referenzleitung, dessen anderes Source/Drain-Gebiet (16b) mit einer Bitleitung und dessen Gateelektrode (19a) mit einer Wortleitung verbunden ist und bei dem ein Stromfluß zwischen den Source/Drain-Gebieten (16a, 16b) im wesentlichen senkrecht zu der Hauptfläche verläuft,
- bei der die Speicherzellen erste Speicherzellen umfassen, in denen ein erster logischer Wert dadurch gespeichert ist, daß die Dicke des Gatedielektrikums (18) so bemessen ist, daß bei Anliegen eines Auswahlsignals an der Wortleitung (19a) ein Strom über die Bitleitung (16b) fließt,
- bei der die Speicherzellen zweite Speicherzellen umfassen, in denen ein zweiter logischer Wert dadurch gespeichert ist, daß die Dicke des Gatedielektrikums (15) so bemessen ist, daß bei Anliegen des Auswahlsignals an der Wortleitung (19a) kein Strom über die Bitleitung (16b) fließt.

2. Speicherzellenanordnung nach Anspruch 1,
- bei der das Substrat (11) mindestens im Bereich der Hauptfläche monokristallines Silizium umfaßt,
- bei der in der Hauptfläche im wesentlichen parallele Gräben (12) verlaufen,
- bei der die Source/Drain-Gebiete (16a, 16b) und das Kanalgebiet (11) jeweils an die Oberfläche des jeweiligen Grabens (12) angrenzen, wobei das Kanalgebiet an eine zur Hauptfläche senkrechte Flanke des Grabens (12) angrenzt,
- bei der an jeden Graben (12) mehrere MOS-Transistoren angrenzen.

3. Speicherzellenanordnung nach Anspruch 2,
bei der die Dicke des Gatedielektrikums (15) der MOS-Transistoren in den zweiten Speicherzellen mindestens das Zehnfache der Dicke des Gatedielektrikums (18) der MOS-Transistoren in den ersten Speicherzellen beträgt.

4. Speicherzellenanordnung nach Anspruch 2 oder 3, bei der eine erste Flanke jedes Grabens mit einer Isolationsschicht (15) versehen ist, während die Kanalgebiete der an den jeweiligen Graben (12) angrenzenden MOS-Transistoren an eine der ersten Flanke gegenüberliegende zweite Flanke des jeweiligen Grabens (12) angrenzen.

5. Speicherzelleanordnung nach Anspruch 2 oder 3,
- bei der jeder Graben (23) eine erste Flanke und eine zweite Flanke aufweist, die einander gegenüberliegen,
- bei der sowohl entlang der ersten Flanke als auch entlang der zweiten Flanke MOS-Transistoren angeordnet sind,
- bei der die Gateelektroden (211a) der MOS-Transistoren als Flankenbedeckung (Spacer) aus leitfähigem Material ausgebildet sind,
- bei der in den zweiten Speicherzellen zwischen der Gateelektrode (211a) und der jeweiligen Flanke des Grabens (23) eine isolierende Flankenbedeckung (27) angeordnet ist,
- bei der die Gateelektroden (211a) der entlang der ersten Flanke eines Grabens (23) angeordneten MOS-Transistoren von den Gateelektroden entlang der zweiten Flanke desselben Grabens (23) angeordneten MOS-Transistoren elektrisch isoliert sind.

6. Speicherzellenanordnung nach Anspruch 5,
- bei der die Gateelektroden (211a) von entlang einer Flanke angeordneten MOS-Transistoren als durchgehende Flankenbedeckung realisiert sind, die eine Wortleitung bildet und die am Rand des Zellenfeldes (24) einen Kontakt aufweist,
- bei der die Kontakte zu benachbarten Wortleitungen (211a) auf gegenüberliegenden Seiten des Zellenfeldes angeordnet sind,
- bei der auf einer Seite des Zellenfeldes angeordnete Kontakte gegeneinander versetzt angeordnet sind.

7. Speicherzellenanordnung nach einem der Ansprüche 1 bis 6, bei der das Substrat zusätzlich außerhalb des Zellenfeldes angeordnete MOS-Transistoren einer Ausleseschaltung umfaßt.

8. Verfahren zur Herstellung einer Festwert-Speicherzellenanordnung gemäß einem der Ansprüche 1-7,
- bei dem in einem Substrat (11) aus Halbleitermaterial ein Zellenfeld (13) mit Speicherzellen mit jeweils einem MOS-Transistor erzeugt wird,
- bei dem in einer Hauptfläche des Substrats (11) im wesentlichen parallel verlaufende Gräben (12) geätzt werden,
- bei dem für die MOS-Transistoren in dem Substrat (11) dotierte Gebiete (16) erzeugt werden, die an die Oberfläche eines Grabens (12) angrenzen, wobei Kanalgebiete jeweils an eine zur Hauptfläche senkrechte Flanke des Grabens (12) angrenzen und wobei in jedem Graben mehrere MOS-Transistoren angrenzen,
- bei dem auf der Oberfläche der Kanalgebiete jeweils ein Gatedielektrikum (15, 18) und eine Gateelektrode (19a) erzeugt werden,
- bei dem das Gatedielektrikum (18) in MOS-Transistoren, die einen ersten logischen Wert speichern, in einer geringeren Dicke erzeugt wird als in MOS-Transistoren, die einen zweiten logischen Wert speichert, so daß bei Anlegen eines Auslesesignals an die Gateelektrode (19a) eines MOS-Transistors, der den ersten logischen Wert speichert, ein Strom durch den MOS-Transistor fließt, während bei Anlegen desselben Auslesesignals an die Gateelektrode (19a) eines MOS-Transistors, der den zweiten logischen Wert speichert, kein Strom durch den MOS-Transistor fließt.

9. Verfahren nach Anspruch 8,
- bei dem das Substrat (11) von einem ersten Leitfähigkeitstyp dotiert ist,
- bei dem nach der Ätzung der Gräben (12) ganzflächig eine isolierende Schicht (15) mit im wesentlichen konformer Kantenbedeckung aufgebracht wird,
- bei dem eine Implantation mit von einem zweiten, zum ersten entgegengesetzten Leitfähigkeitstyp dotierenden Ionen durchgeführt wird, bei der am Boden der Gräben (12) und in der Hauptfläche zwischen den Gräben (12) dotierte Gebiete (16) erzeugt werden,
- bei dem unter Verwendung einer Photolackmaske die isolierende Schicht (15) mindestens entlang denjenigen Flanken der Gräben (12) durch eine Ätzung entfernt wird, an die Kanalgebiete von MOS-Transistoren angrenzen, die den ersten logischen Wert speichern,
- bei dem eine Gateoxidation durchgeführt wird, um an den freigelegten Flanken der Gräben (12) jeweils das Gatedielektrikum (18) zu erzeugen,
- bei dem eine leitfähige Schicht (19) mit im wesentlichen konformer Kantenbedeckung abgeschieden wird,
- bei dem zur Bildung der Gateelektroden (19a) die leitfähige Schicht so strukturiert wird, daß quer zu den Gräben (12) verlaufende streifenförmige Wortleitungen (19a) entstehen,
- bei dem die dotierten Gebiete (16a, 16b) am Boden der Gräben (12) und zwischen den Gräben (12) am Rand des Zellenfeldes (13) mit Kontakten versehen werden.

10. Verfahren nach Anspruch 9,
- bei dem bei der Implantation zur Erzeugung der dotierten Gebiete (16) im Zellenfeld zusätzlich außerhalb des Zellenfeldes Source/Drain-Gebiete für MOS-Transistoren einer Ansteuerschaltung gebildet werden,
- bei dem bei der Gateoxidation Gatedielektrika für die MOS-Transistoren der Ansteuerschaltungen gebildet werden,
- bei dem bei der Strukturierung der leitfähigen Schicht (19) aus der leitfähigen Schicht (19) Gateelektroden der MOS-Transistoren der Ansteuerschaltung gebildet werden.

11. Verfahren nach Anspruch 9 oder 10,
- bei dem das Substrat aus monokristallinem Silizium besteht,
- bei dem die isolierende Schicht (15) aus SiO₂ gebildet wird,
- bei dem das Gatedielektrikum aus SiO₂ gebildet wird,
- bei dem die leitfähige Schicht (19) aus dotiertem Polysilizium gebildet wird.

12. Verfahren nach Anspruch 8,
- bei dem das Substrat (21) von einem ersten Leitfähigkeitstyp dotiert ist,
- bei dem eine von einem zweiten, zum ersten entgegengesetzten Leitfähigkeitstyp dotierte Wanne (22) erzeugt wird, die an die Hauptfläche angrenzt und die mindestens den Bereich für das Zellenfeld (24) überdeckt,
- bei dem die Gräben (23) so tief geätzt werden, daß mindestens am Boden der Gräben das vom ersten Leitfähigkeitstyp dotierte Substrat (21) freigelegt ist,
- bei dem ganzflächig eine isolierende Schicht (25) erzeugt wird,
- bei dem unter Verwendung einer Maske durch eine Ätzung die isolierende Schicht (25) entlang denjenigen Flanken der Gräben (23) entfernt wird, an die MOS-Transistoren angrenzen, die den ersten logischen Wert speichern,
- bei dem nach Entfernen der Maske durch eine anisotrope, zum Substrat (21) selektive Ätzung aus der strukturierten isolierenden Schicht (25) isolierende Flankenbedeckungen (27) gebildet werden,
- bei dem eine Gateoxidation durchgeführt wird, um an den freigelegten Flanken der Gräben (23) jeweils eine Gateoxidschicht zu erzeugen,
- bei dem eine leitfähige Schicht mit im wesentlichen konformer Kantenbedeckung abgeschieden wird,
- bei dem durch eine anisotrope, selektive Ätzung aus der leitfähigen Schicht leitfähige Flankenbedeckungen (211) gebildet werden, die die Flanken der Gräben (23) ringförmig auskleiden,
- bei dem die ringförmigen leitfähigen Flankenbedeckungen (211) durch eine Ätzung jeweils an mindestens zwei Stellen unterbrochen werden,
- bei dem ganzflächig eine planarisierende Isolationsschicht erzeugt wird,
- bei dem in die planarisierende Isolationsschicht (217) Kontaktlöcher (218) geätzt werden, die auf die Oberfläche der dotierten Wanne (22) reichen,
- bei dem durch Implantation dotierte Source/Drain-Gebiete (219) erzeugt werden, die im Bereich der Kontaktlöcher (218) an die Hauptfläche angrenzen,
- bei dem die Kontaktlöcher (218) mit einer Metallisierung (221) versehen werden,
- bei dem am Rand des Zellenfeldes Kontakte zu den leitfähigen Flankenbedeckungen (211a) gebildet werden.

13. Verfahren nach Anspruch 12,
bei dem vor der Bildung der Metallisierung (221) in den Kontaktlöchern (218) eine isolierende Schicht mit im wesentlichen konformer Kantenbedeckung abgeschieden wird, die in einer anisotropen, selektiven Ätzung geätzt wird, wobei die Oberfläche der an die Hauptfläche angrenzenden Source/Drain-Gebiete (219) mindestens teilweise freigelegt wird.

14. Verfahren nach Anspruch 12 oder 13,
bei dem zur Isolation zwischen entlang einem Graben (23) benachbarten Source/Drain-Gebieten (219) isolierende Gräben erzeugt werden, die durch eine Grabenatzung und Auffüllung mit isolierendem Material vor der Ätzung der zuerst genannten Gräben (23) hergestellt werden.

15. Verfahren nach einem der Ansprüche 12 bis 14,
- bei dem aus der leitfähigen Schicht (29) außerhalb des Zellenfeldes (24) zusätzlich Gateelektroden (214) für MOS-Transistoren einer Ansteuerschaltung gebildet werden,
- bei dem vor dem Aufbringen der planarisierenden Isolationsschicht (217) durch Implantation vom ersten Leitfähigkeitstyp dotierte Source/Drain-Gebiete (216) für die MOS-Transistoren der Ansteuerschaltung gebildet werden.

16. Verfahren nach einem der Ansprüche 12 bis 15,
- bei dem das Substrat (21) aus monokristallinem Silizium besteht,
- bei dem die isolierende Schicht (25) und die Gateoxidschicht (28) aus SiO₂ gebildet werden,
- bei dem die leitfähige Schicht (29) aus dotiertem Polysilizium gebildet wird,
- bei dem die planarisierende Isolationsschicht (217) aus Bor-Phosphor-Silikat-Glas gebildet wird.

## Claims

1. Read-only-memory cell arrangement
- in the case of which a substrate (11) made of semiconductor material is provided which comprises memory cells arranged in a cell field in the area of one main surface,
- in the case of which the memory cells each comprise an MOS transistor having two source/drain regions (16a, 16b), a channel region (11), a gate dielectric (18; 15) and a gate electrode (19a), one of whose source/drain regions (16a) is connected to a reference line and whose other source/drain region (16b) is connected to a bit line, and whose gate electrode (19a) is connected to a word line, and in the case of which a current flow runs between the source/drain regions (16a, 16b) essentially at right angles to the main surface,
- in the case of which the memory cells comprise first memory cells in which a first logic value is stored in that the thickness of the gate dielectric (18) is dimensioned such that a current flows via the bit line (16b) when a selection signal is applied to the word line (19a),
- in the case of which the memory cells comprise second memory cells in which a second logic value is stored in that the thickness of the gate dielectric (15) is dimensioned such that no current flows via the bit line (16b) when the selection signal is applied to the word line (19a).

2. Memory cell arrangement according to Claim 1,
- in the case of which the substrate (11) comprises monocrystalline silicon, at least in the region of the main surface,
- in the case of which essentially parallel trenches (12) run in the main surface,
- in the case of which the source/drain regions (16a, 16b) and the channel region (11) in each case abut the surface of the respective trench (12), the channel region abutting a flank of the trench (12) which flank is at right angles to the main surface,
- in the case of which a plurality of MOS transistors abut each trench (12).

3. Memory cell arrangement according to Claim 2, in the case of which the thickness of the gate dielectric (15) of the MOS transistors in the second memory cells is at least ten times the thickness of the gate dielectric (18) of the MOS transistors in the first memory cells.

4. Memory cell arrangement according to Claim 2 or 3, in the case of which a first flank of each trench is provided with an insulation layer (15), while the channel regions of the MOS transistors which abut the respective trench (12) abut a second flank of the respective trench (12), which second flank is opposite the first flank.

5. Memory cell arrangement according to Claim 2 or 3,
- in the case of which each trench (23) has a first flank and a second flank, which are opposite one another,
- in the case of which MOS transistors are arranged along the first flank and along the second flank,
- in the case of which the gate electrodes (211a) of the MOS transistors are designed as flank covering (spacer) made of conductive material,
- in the case of which an insulating flank covering (27) is arranged in the second memory cells between the gate electrode (211a) and the respective flank of the trench (23),
- in the case of which the gate electrodes (211a) of the MOS transistors which are arranged along the first flank of a trench (23) are electrically insulated from the gate electrodes of the MOS transistors which are arranged along the second flank of the same trench (23).

6. Memory cell arrangement according to Claim 5,
- in the case of which the gate electrodes (211a) of MOS transistors which are arranged along one flank are implemented as continuous flank covering which forms a word line and has a contact at the edge of the cell field (24),
- in the case of which the contacts to adjacent word lines (211a) are arranged on opposite sides of the cell field,
- in the case of which contacts which are arranged on one side of the cell field are arranged offset.

7. Memory cell arrangement according to one of Claims 1 to 6, in the case of which the substrate additionally comprises MOS transistors, which are arranged outside the cell field, of a read-out circuit.

8. Method for production of a read-only-memory cell arrangement according to one of Claims 1 - 7,
- in the case of which a cell field (13) having memory cells with in each case one MOS transistor is produced in a substrate (11) made of semiconductor material,
- in the case of which trenches (12) which run essentially parallel are etched in one main surface of the substrate (11),
- in the case of which doped regions (16) are produced for the MOS transistors in the substrate (11), which doped regions (16) abut the surface of a trench (12), channel regions in each case abutting a flank of the trench (12) which flank is at right angles to the main surface, and a plurality of MOS transistors abutting each trench,
- in the case of which a gate dielectric (15, 18) and a gate electrode (19a) are in each case produced on the surface of the channel regions,
- in the case of which the gate dielectric (18) is produced with a smaller thickness in MOS transistors which store a first logic value than in MOS transistors which store a second logic value, such that a current flows through the MOS transistor when a read-out signal is applied to the gate electrode (19a) of an MOS transistor which is storing the first logic value, while no current flows through the MOS transistor when the same read-out signal is applied to the gate electrode (19a) of an MOS transistor which is storing the second logic value.

9. Method according to Claim 8,
- in the case of which the substrate (11) is doped by a first conductance type,
- in the case of which, after the etching of the trenches (12), an insulating layer (15) having an essentially conformal edge covering is applied over the entire area,
- in the case of which an implantation is carried out using ions doped by a second conductance type, which is opposite to the first conductance type, during which implantation doped regions (16) are produced on the base of the trenches (12) and in the main surface between the trenches (12),
- in the case of which the insulating layer (15) is removed by etching, using a photoresist mask, at least along those flanks of the trenches (12) abuted by the channel regions of MOS transistors which store the first logic value,
- in the case of which a gate oxidation is carried out in order to produce the gate dielectric (18) in each case on the exposed flanks of the trenches (12),
- in the case of which a conductive layer (19) having essentially conformal edge covering is deposited,
- in the case of which, in order to form the gate electrodes (19a), the conductive layer is structured such that word lines (19a) are produced which are in the form of strips and run transversely with respect to the trenches (12),
- in the case of which the doped regions (16a, 16b) on the base of the trenches (12) and between the trenches (12) are provided with contacts at the edge of the cell field (13).

10. Method according to Claim 9,
- in the case of which, during the implantation in order to produce the doped regions (16) in the cell field, source/drain regions for MOS transistors of a drive circuit are additionally formed outside the cell field,
- in the case of which, during the gate oxidation, gate dielectrics are formed for the MOS transistors of the drive circuits,
- in the case of which, during the structuring of the conductive layer (19) gate electrodes of the MOS transistors of the drive circuit are formed from the conductive layer (19).

11. Method according to Claim 9 or 10,
- in the case of which the substrate is composed of monocrystalline silicon,
- in the case of which the insulating layer (15) is formed from SiO₂,
- in the case of which the gate dielectric is formed from SiO₂,
- in the case of which the conductive layer (19) is formed from doped polysilicon.

12. Method according to Claim 8,
- in the case of which the substrate (21) is doped by a first conductance type,
- in the case of which a well (22) is produced which is doped by a second conductance type, which is opposite to the first conductance type, abuts the main surface and covers at least the area for the cell field (24),
- in the case of which the trenches (23) are etched so deeply that the substrate (21) which is doped by the first conductance type is exposed at least on the base of the trenches,
- in the case of which an insulating layer (25) is produced over the entire area,
- in the case of which the insulating layer (25) is removed by etching, using a mask, along those flanks of the trenches (23) which abut the MOS transistors which store the first logic value,
- in the case of which, after removal of the mask by means of an anisotropic etching which is selective with respect to the substrate (21), insulating flank coverings (27) are formed from the structured insulating layer (25),
- in the case of which a gate oxidation is carried out in order to produce a gate oxide layer in each case on the exposed flanks of the trenches (23),
- in the case of which a conductive layer having essentially conformal edge covering is deposited,
- in the case of which conductive flank coverings (211), which line the flanks of the trenches (23) in an annular shape, are formed from the conductive layer by anisotropic, selective etching,
- in the case of which, the annular, conductive flank coverings (211) are interrupted by etching in each case at at least two points,
- in the case of which a planarizing insulation layer is produced over the entire area,
- in the case of which contact holes (218), which extend to the surface of the doped well (22), are etched in the planarizing insulation layer (217),
- in the case of which doped source/drain regions (219), which abut the main surface in the area of the contact holes (218), are produced by implantation,
- in the case of which the contact holes (218) are provided with a metallization (221),
- in the case of which contacts to the conductive flank coverings (211a) are formed at the edge of the cell field.

13. Method according to Claim 12, in the case of which an insulating layer having essentially conformal edge covering is deposited in the contact holes (218) before the formation of the metallization (221), which insulating layer is etched using an anisotropic, selective etching, the surface of the source/drain regions (219) which abut the main surface being at least partially exposed.

14. Method according to Claim 12 or 13, in the case of which insulating trenches are produced, for insulation, between source/drain regions (219) which are adjacent along a trench (23), which insulating trenches are produced by trench etching and filling with insulating material before the etching of the first-mentioned trenches (23) .

15. Method according to one of Claims 12 to 14,
- in the case of which gate electrodes (214) for MOS transistors of a drive circuit are additionally formed from the conductive layer (29) outside the cell field (24),
- in the case of which source/drain regions (216), which are doped by the first conductance type, for the MOS transistors of the drive circuit are formed by implantation before the application of the planarizing insulation layer (217).

16. Method according to one of Claims 12 to 15,
- in the case of which the substrate (21) is composed of monocrystalline silicon,
- in the case of which the insulating layer (25) and the gate oxide layer (28) are formed from SiO₂,
- in the case of which the conductive layer (29) is formed from doped polysilicon,
- in the case of which the planarizing insulation layer (217) is formed from boron-phosphorus-silicate glass.

## Revendications

1. Dispositif de cellules de mémoire à valeur fixe
- dans lequel un substrat (11) en matériau semiconducteur est prévu, qui comprend dans la partie d'une surface principale des cellules de mémoire disposées dans un champ de cellules,
- dans lequel les cellules de mémoire comprennent respectivement un transistor MOS avec deux zones source-drain (16a, 16b), une zone de canal (11), un diélectrique de grille (18 ; 15) et une électrode de grille (19a), dont une zone source-drain (16a) est reliée à une ligne de référence, dont l'autre zone source-drain (16b) est reliée à une ligne de bit et dont l'électrode de grille (19a) est reliée à une ligne de mot, et dans lequel un courant véhiculé entre les zones source-drain (16a, 16b) s'étend essentiellement verticalement par rapport à la surface principale,
- dans lequel les cellules de mémoire comprennent des premières cellules de mémoire où est stockée une première valeur logique grâce au fait que l'épaisseur du diélectrique de grille (18) est dimensionnée de telle sorte que lorsqu'un signal de sélection est appliqué à la ligne de mot (19a), un courant traverse la ligne de bit (16b),
- dans lequel les cellules de mémoire comprennent des deuxièmes cellules de mémoire où est stockée une deuxième valeur logique grâce au fait que l'épaisseur du diélectrique de grille (15) est dimensionnée de telle sorte que lorsque le signal de sélection est appliqué à la ligne de mot (19a), aucun courant traverse la ligne de bit (16b).

2. Dispositif de cellules de mémoire selon la revendication 1,
- dans lequel le substrat (11) comporte au moins dans la partie de la surface principale un silicium monocristallin,
- dans lequel des tranchées (12) essentiellement parallèles s'étendent dans la surface principale,
- dans lequel les zones source-drain (16a, 16b) et la zone de canal (11) sont chacune contiguës à la surface de la tranchée (12) respective, la zone de canal étant contiguë à un flanc vertical par rapport à la surface principale de la tranchée (12),
- dans lequel plusieurs transistors MOS sont contigus à chaque tranchée (12).

3. Dispositif de cellules de mémoire selon la revendication 2, dans lequel l'épaisseur du diélectrique de grille (15) des transistors MOS dans les deuxièmes cellules de mémoire fait au moins 10 fois l'épaisseur du diélectrique de grille (18) des transistors MOS dans les premières cellules de mémoire.

4. Dispositif de cellules de mémoire selon la revendication 2 ou 3, dans lequel un premier flanc de chaque tranchée est pourvu d'une couche isolante (15), tandis que les zones de canal des transistors MOS contigus à la tranchée (12) respective sont contiguës à un deuxième flanc opposé au premier flanc de la tranchée (12) respective.

5. Dispositif de cellules de mémoire selon la revendication 2 ou 3,
- dans lequel chaque tranchée (23) comporte un premier flanc et un deuxième flanc opposés l'un à l'autre,
- dans lequel des transistors MOS sont disposés aussi bien le long du premier flanc que le long du deuxième flanc,
- dans lequel les électrodes de grille (211a) des transistors MOS sont réalisées sous forme de recouvrement de flanc (spacer) en matériau conducteur,
- dans lequel un recouvrement de flanc (27) isolant est disposé dans les deuxièmes cellules de mémoire, entre l'électrode de grille (211a) et le flanc respectif de la tranchée (23),
- dans lequel les électrodes de grille (211a) des transistors MOS disposés le long du premier flanc d'une tranchée (23) sont isolées électriquement des électrodes de grille des transistors MOS disposés le long du deuxième flanc de la même tranchée (23).

6. Dispositif de cellules de mémoire selon la revendication 5,
- dans lequel les électrodes de grille (211a) de transistors MOS disposés le long d'un flanc sont réalisées sous forme de recouvrement de flanc continu formant une ligne de mot et comportant au bord du champ de cellules (24) un contact,
- dans lequel les contacts avec des lignes de mot (211a) voisines sont disposés sur des côtés opposés du champ de cellules,
- dans lequel les contacts disposés sur l'un des côtés du champ de cellules sont décalés l'un par rapport à l'autre.

7. Dispositif de cellules de mémoire selon l'une des revendications 1 à 6, dans lequel le substrat comporte en plus des transistors MOS d'un circuit de sélection, disposés en dehors du champ de cellules.

8. Procédé de fabrication d'un dispositif de cellules de mémoire à valeur fixe selon l'une des revendications 1 à 7,
- dans lequel on crée dans un substrat (11) en matériau semiconducteur un champ de cellules (13) comportant des cellules de mémoire avec respectivement un transistor MOS,
- dans lequel on grave dans une surface principale du substrat (11) des tranchées (12) s'étendant essentiellement parallèlement,
- dans lequel on crée pour les transistors MOS, dans le substrat (11), des zones dopées (16), qui sont contiguës à la surface d'une tranchée (12), les zones de canal étant à chaque fois contiguës à un flanc vertical par rapport à la surface principale de la tranchée (12) et dans chaque tranchée, plusieurs transistors MOS étant contigus,
- dans lequel on réalise sur la surface des zones de canal respectivement un diélectrique de grille (15, 18) et une électrode de grille (19a),
- dans lequel on réalise le diélectrique de grille (18) de transistors MOS stockant une première valeur logique en une épaisseur inférieure à celle de transistors MOS stockant une deuxième valeur logique, de sorte que, lorsqu'un signal de sélection est appliqué à l'électrode de grille (19a) d'un transistor MOS stockant la première valeur logique, un courant traverse le transistor MOS, tandis que, lorsque le même signal de sélection est appliqué à l'électrode de grille (19a) d'un transistor MOS stockant la deuxième valeur logique, aucun courant traverse le transistor MOS.

9. Procédé selon la revendication 8,
- dans lequel le substrat (11) est dopé d'un premier type de conductivité,
- dans lequel, après gravure des tranchées (12), on dépose sur toute la surface une couche isolante (15) à recouvrement de bord essentiellement conforme,
- dans lequel on procède à une implantation d'ions dopant d'un deuxième type de conductivité opposé au premier, lors de laquelle on crée, au fond des tranchées (12) et dans la surface principale entre les tranchées (12), des zones dopées (16),
- dans lequel, en utilisant un masque en laque photosensible, on supprime par gravure la couche isolante (15) au moins le long de ceux parmi les flancs des tranchées (12), auxquels sont contiguës les zones de canal de transistors MOS stockant la première valeur logique,
- dans lequel on procède à une oxydation de grille pour créer à chaque flanc dégagé des tranchées (12) le diélectrique de grille (18),
- dans lequel on dépose une couche conductrice (19) à recouvrement de bord essentiellement conforme,
- dans lequel, pour former les électrodes de grille (19a), on structure la couche conductrice, de manière à obtenir des lignes de mot (19a) s'étendant perpendiculairement par rapport aux tranchées (12),
- dans lequel on munit les zones dopées (16a, 16b), au fond des tranchées (12) et entre les tranchées (12) au bord du champ de cellules, de contacts.

10. Procédé selon la revendication 9,
- dans lequel, lors de l'implantation pour créer les zones dopées (16) dans le champ de cellules, on réalise en plus en dehors du champ de cellules, des zones source-drain de transistors MOS d'un circuit de sélection,
- dans lequel, lors de l'oxydation de grille, on réalise des diélectriques de grille pour les transistors MOS des circuits de sélection,
- dans lequel, lors de la structuration de la couche conductrice (19), on réalise à partir de la couche conductrice (19) des électrodes de grille pour les transistors MOS du circuit de sélection.

11. Procédé selon la revendication 9 ou 10,
- dans lequel le substrat est en silicium monocristallin,
- dans lequel la couche isolante (15) est réalisée en SiO2,
- dans lequel le diélectrique de grille est réalisé en SiO2,
- dans lequel la couche conductrice (19) est réalisée en polysilicium dopé.

12. Procédé selon la revendication 8,
- dans lequel le substrat (21) est dopé d'un premier type de conductivité,
- dans lequel on crée une cuvette (22) dopée d'un deuxième type de conductivité opposé au premier, qui est contiguë à la surface principale et qui couvre au moins la zone du champ de cellules (24),
- dans lequel on grave les tranchées (23) de façon si profonde que le substrat (21) dopé du premier type de conductivité est dégagé au moins au fond des tranchées,
- dans lequel on crée sur toute la surface une couche isolante (25),
- dans lequel, en utilisant un masque, on supprime par gravure la couche isolante (25) le long de ceux parmi les flancs des tranchées (23), auxquels sont contigus des transistors MOS stockant la première valeur logique,
- dans lequel, après suppression du masque, on réalise par gravure anisotrope sélective par rapport au substrat (21), à partir de la couche isolante structurée (25), des recouvrements de flanc (27) isolants,
- dans lequel on procède à une oxydation de grille pour créer aux flancs dégagés des tranchées (23) respectivement une couche d'oxyde de grille,
- dans lequel on dépose une couche conductrice à recouvrement de flanc essentiellement conforme,
- dans lequel on réalise par gravure anisotrope sélective, à partir de la couche conductrice, des recouvrements de flanc (211) conducteurs, qui garnissent les flancs des tranchées (23) en forme d'anneau,
- dans lequel on coupe les recouvrements de flanc (211) conducteurs en forme d'anneau, par gravure, à chaque fois à au moins deux endroits,
- dans lequel on crée sur toute la surface une couche isolante de planarisation,
- dans lequel on grave dans la couche isolante (217) de planarisation des trous de contact (218) qui aboutissent sur la surface de la cuvette (22) dopée,
- dans lequel on crée par implantation des zones source-drain (219) dopées qui, dans la partie des trous de contact (218), sont contiguës à la surface principale,
- dans lequel on munit les trous de contact (218) d'une métallisation (221),
- dans lequel on réalise au bord du champ de cellules, des contacts avec les recouvrements de flanc (211a) conducteurs.

13. Procédé selon la revendication 12, dans lequel, avant la réalisation de la métallisation (221), une couche isolante à recouvrement de bord essentiellement conforme est déposée dans les trous de contact (218) qui est gravée par gravure anisotrope sélective, ce qui fait que la surface des zones source-drain (219) contiguës à la surface principale est dégagée au moins partiellement.

14. Procédé selon la revendication 12 ou 13, dans lequel, pour assurer l'isolation, on crée entre les zones source-drain (219) voisines le long d'une tranchée (23), des tranchées isolantes réalisées par gravure de tranchées et par remplissage de matériau isolant avant la gravure des tranchées (23) citées en premier.

15. Procédé selon l'une des revendications 12 à 14,
- dans lequel on réalise en plus à partir de la couche conductrice (29), en dehors du champ de cellules (24), des électrodes de grille (214) pour des transistors MOS d'un circuit de sélection,
- dans lequel, avant de déposer la couche isolante (217) de planarisation, on réalise par implantation du premier type de conductivité des zones source-drain (216) dopées pour les transistors MOS du circuit de sélection,

16. Procédé selon l'une des revendications 12 à 15,
- dans lequel le substrat (21) est en silicium monocristallin,
- dans lequel la couche isolante (25) et la couche d'oxyde de grille (28) sont réalisées en SiO₂,
- dans lequel la couche conductrice (29) est réalisée en polysilicium dopé,
- dans lequel la couche isolante (217) de planarisation est réalisée en verre de borophosphoresilicate.
